(19) Europäisches Patentamt / European Patent Office / Office européen des brevets

(11) **EP 2 517 221 B1**

(12) **EUROPEAN PATENT SPECIFICATION**

(45) Date of publication and mention
of the grant of the patent:
**30.07.2014 Bulletin 2014/31**

(51) Int Cl.:
***H01G 9/20*** *(2006.01)*

(21) Application number: **10776387.2**

(22) Date of filing: **17.11.2010**

(86) International application number:
**PCT/EP2010/067667**

(87) International publication number:
**WO 2011/076492 (30.06.2011 Gazette 2011/26)**

(54) **Dye Sensitized Solar Cell**

Farbstoffsolarzelle

CELULE SOLAIRE À COLLORANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.12.2009 IT MI20092245**

(43) Date of publication of application:
**31.10.2012 Bulletin 2012/44**

(73) Proprietor: **SAES GETTERS S.p.A.**
**Lainate (Milano) (IT)**

(72) Inventors:
• **BONUCCI, Antonio**
  **I-20151 Milano MI (IT)**
• **MACCHI, Roberto**
  **I-21058 Solbiate Olona VA (IT)**
• **GIANNANTONIO, Roberto**
  **I-28047 Oleggio NO (IT)**

(74) Representative: **Pizzoli, Antonio et al**
**Società Italiana Brevetti SpA**
**Via G. Carducci 8**
**20123 Milano (IT)**

(56) References cited:
**EP-A1- 1 619 700     WO-A2-2009/048267**

• **M. G. KANG, N.-G. PARK, S. H. CHANG, S. H. CHOI, K.-J. KIM: "Enhanced photocurrent of Ru (II)-dye-sensitized solar cells by incorporation of titanium silicate-2 in tiO2 film", BULL. KOREAN. CHEM. SOC., vol. 23, no. 1, 2002, pages 140-142, XP002591038,**
• **ATIENZAR P ET AL: "Titanium-containing zeolites and microporous molecular sieves as photovoltaic solar cells", CHEMPHYSCHEM WILEY GERMANY, vol. 8, no. 7, 2007, pages 1115-1119, XP002591070, ISSN: 1439-4235, DOI: DOI:10.1002/CPHC.200700019**
• **EASWARAMOORTHI ET AL: "Photophysical properties of phenosafranine (PHNS) adsorbed on the TiO2-incorporated zeolite-Y", MICROPOROUS AND MESOPOROUS MATERIALS, ELSEVIER SCIENCE PUBLISHING, NEW YORK, US LNKD- DOI: 10.1016/J.MICROMESO.2005.07.009, vol. 86, no. 1-3, 28 November 2005 (2005-11-28), pages 185-190, XP005159945, ISSN: 1387-1811**

## Description

The present invention relates to a solar cell, especially to a DSC type solar cell. Different types of solar cells are known in the field of the devices for converting solar energy into electric energy.

Among them the DSC type solar cells, which are also known under the acronym DSSC (Dye-Sensitized Solar Cell), are a relatively new class of devices. They based on a photo-electrochemical system formed of a pair of electrodes, one of which is sensitive to the luminous radiation and between which an electrolyte is arranged.

DSC solar cells have attracted and attract a great interest from the manufacturers of this type of devices because of their main characteristics. In fact, they are made of cheap materials, are mechanically resistant and do not require complex apparatuses for their manufacturing, thus allowing to foresee interesting advantages in terms of costs in the manufacturing on an industrial scale when compared to the already known devices in the field, i.e. the solid-state solar cells.

A DSC solar cell has a sandwich structure: a pair of electrodes are separated by an electrolytic solution and by a metal oxide layer (usually titanium dioxide) coated with a layer of a photosensitizing material.

The photosensitizing material is a dye capable of transferring electrons to the layer of titanium dioxide upon the sorption of photons.

The particles forming the layer of metal oxide have nanometric size, because it facilitates the adhesion of the layer of photosensitizing dye. In order to further improve the adhesion of the photosensitizing dye, the layer of metal oxide is thermally treated, thus being provided with a tridimensional micro-porous structure that strongly increases its surface. It allows to apply a larger amount of dye on a given volume and therefore to reach a higher efficiency in the sorption of the light and in the conversion of energy.

The electrolytic solution, generally based on iodine and potassium iodide, forms an oxidation-reduction system that serves to provide the dye with electrons that are "lost" when its molecules are irradiated by UV (Ultra-Violet) rays. The oxidation-reduction cycle can be indefinitely repeated.

When a DSC solar cell is operating, the light radiation penetrates through the upper electrode, which typically comprises a layer of glass or of a similar transparent material, thus striking the molecules of the dye deposited on the surface of the metal oxide. The photons striking the dye with a sufficient high level of energy to be sorbed, generate an excited state of the dye molecule from which an electron can be "injected" directly in the conductive band of the metal oxide and moves therefrom towards the anode of the cell due to chemical diffusion gradient. Meanwhile, the dye molecule recovers the electron lost through to the oxidation-reduction reaction that occurs in the electrolyte. This electron reaction with the oxidized dye molecule occurs faster than the electron injection into the metal oxide layer. The electrolyte thus recovers its missing electron by diffusing towards the bottom of the cell, where the counter-electrode, generally made of platinum, reintroduces the electrons after they have flown through the external circuit. In this way it is possible to avoid the recombination reaction between the oxidized dye and the electron, which would strongly reduce the efficiency of the solar cell.

Therefore, the metal oxide acts as an electron receiving member, the organic dye as an electro-chemical pump, while the electrolytic solution as a donor of electrons.

Among the components of a DSC solar cell, the metal oxide layer is considered as the heart of the system by those skilled in the art.

Titanium dioxide is not the only metal oxide that can be used for the manufacturing of DSC type solar cells. The publication US 20080115831 A1 discloses, for example, several metal oxides alternative to titanium dioxide, among which e.g. aluminum oxide and nanozeolites that can serve as electron receiving member.

The use of nanozeolites as possible candidate of metal oxide is also disclosed in the publication JP 20052516005 A, which also points out that an efficient photoelectric conversion may be obtained by controlling both the light diffusion and its transmission through the metal oxide layer. In particular, the structure of the metal oxide must preferably be porous and formed by microparticles having an irregular structure.

The importance of the structural properties and the morphology of the members of a solar cell in order to improve the conversion of energy is also described in the publication JP 200841746 A. It discloses a substrate for a solar cell made of a thermoplastic crystalline resin containing inert particles. These powders have a surface roughness comprised in the range between 30 and 500 $\mu$m.

The publication JP 2008201655 discloses DSC type solar cells in which the particles of titanium dioxide are dispersed in a binding medium comprising exchanged zeolites and other elements, thus forming a composite layer of metal oxide having better properties in terms of electron compensation.

The publication JP 2006124267 A discloses the use of titanium dioxide particles in the manufacturing of DSC type solar cells. It is remarked that in order to obtain a good transparency of the metal oxide layer it is necessary that the particle size is about the half of the wave length of the visible light. The publication also discloses the use of adsorbing agents such as active carbons and zeolites in order to remove bad smells generated by the impurities present in the system.

In order to improve the performances of a DSC type solar cell it is desirable to increase the efficiency in light absorption. Concerning this aspect it is known that titanium particles having a high refraction index increase the light sorption in a DSC cell, because they effectively diffuse the light. The light, being repeatedly reflected on the walls of the particles, reaches the deeper layers of cell, thus increasing the sorption possibilities. However, since the surface area of the particles diminishes proportionally as their average diameter increases, it is necessary to find a suitable compromise between the need for light diffusion, which requires larger diameters, and the need for maximizing the surface area, which requires a nanometric size.

The article "Dye sensitized solar cells with conversion efficiency of 11%" by Y. Chiba et al. published on the review J. Appl. Phys. number 45, L638-640 - 2006 discloses a recent study which discovered that is possible to significantly improve the efficiency in the conversion from light to current of a DSC type solar cell in the spectrum range between 400 and 850 nm by inserting titanium particles having a diameter of about 400 nm into layers of titanium dioxide made of particles having an average size in the order of 25 nm when a black dye is used as photosensitizing material.

Kang et al. in the paper published on the Bulletin Korean Chem. Soc. 23 (2002), pages 140-142, discloses a dye sensitized solar cell having a porous electrode of $TiO_2$ and a zeolite (TS-2), wherein the zeolite particles have a diameter of about 500 nm.

Moreover, in order to improve the performances of a DSC type solar cell, it is desirable to limit the desorption phenomenon of the dye from the surface of titanium dioxide. The desorption causes a reduction of the active surface for the separation of the charge and the reduction of the short-circuit current. Among the various causes of this degradation during the aging tests in humid atmosphere, it is believed that the contact with water is one of the mainly responsible factors, as described, for example, by H. Matsui in the article "Thermal stability of dye-sensitized solar cells with current collecting grid", published by Solar Energy Materials and Solar Cells, volume 93, June 2009, pages 1110-1115.

It is therefore an object of the present invention to provide a DSC type solar cell allowing to improve the efficiency of conversion from light to current. Said object is achieved with a DSC solar cell, whose main features are disclosed in the first claim, while other features are disclosed in the dependent claims.

According to the present invention, it is possible to increase the efficiency of conversion from light to current of a DSC type solar cell by making a metal oxide layer comprising particles of titanium dioxide and nanozeolites, wherein the particles of titanium dioxide have a nanometric size, whereas the particles of nanozeolites have a size from ten to one hundred times larger.

The main advantage connected to the use of nanozeolites particles is that they accomplish both a function of diffusing light and a function of sorbing the impurities, water vapor in particular, that are present at the interface between the photosensitizing dye and the layer of titanium dioxide, thus avoiding detrimental phenomena, as for example the above-mentioned dye desorption phenomenon which leads to a reduction of efficiency in the conversion of the light into electric energy.

Moreover, the amount of particles of nanozeolites is suitably selected so as to facilitate the diffusion of the light inside the solar cell but not to affect the total active surface area in the device, on which the sorption level of the photosensitive dye essentially depends.

Further advantages and features of the DSC solar cell according to the present invention will become clear to those skilled in the art from the following detailed and non-limiting description of an embodiment thereof.

The solar cell according to the present invention comprises a sandwich structure formed of a pair of electrodes separated by an electrolytic solution.

The lower electrode serves as a cathode of the cell and is typically made of platinum.

Between the two electrodes an electrolyte is present, e.g. a solution based on iodine and potassium iodide and the assembly so formed is subsequently sealed in order to prevent the leaking out of the electrolyte.

The upper electrode comprises a transparent supporting member, e.g. made of glass, suitable to let the solar light in. On the surface of the supporting member intended to face the inside of the solar cell, there is a thin metal oxide based layer, comprising a mixture of dispersed powders of titanium dioxide and nanozeolites.

As it is known, in order to maximize the surface area of the particles forming the layer of metal oxide, it is desirable that the particle size is as small as possible. However, this does not facilitate the diffusion of the light, whereby it is necessary that the nanozeolite particles used for such a purpose have a larger size. According to the present invention, the titanium dioxide particles forming the metal oxide layer have an average size comprised between 3 and 30 nm, whereas at least a ten percent of the nanozeolite particles has an average size comprised between 200 and 400 nm and preferably a size comprised between 230 and 320 nm.

The average size of a granulometric distribution may be easily defined as the arithmetic medium value, i.e.

$$\frac{\sum_{i=1}^{n} n_i \cdot size_i}{\sum_{i=1}^{n} n_i} \quad .$$

calculated in a selected and continuous size range.

Saying an "amount of at least a ten percent" of nanozeolites it is intended the relative percent amount respect their total particle number.

In one embodiment of the present invention, the amount of nanozeolites not comprised in the above referred range has an average size that is less than 200 nm.

In an alternative embodiment, the nanozeolite particles having an average size comprised between 230 and 320 nm are more than the 50 percent respect their total amount.

In the preferred embodiment the average size calculated over all the nanozeolites used in the invention is comprised in the range between 230 and 320 nm.

In order to obtain a good level of light diffusion inside the metal oxide layer without affecting the size of the surface area, the weight percentage of the nanozeolite powders is comprised between 2 and 30% of the total weight of the layer of metal oxide, preferably between 4 and 10%, more preferably between 4 and 6%.

The metal oxide layer may be deposited on the supporting member by means of various techniques known in the field, such as, for example, "sputtering" screen printing, SPD (Spray Pyrolysis Deposition). Among these techniques screen printing is preferred, followed by a sintering process carried out under dry conditions at 450°C during 30 minutes. Moreover, this process allows to activate the nanozeolites, that accomplish the function of diffusing the light and also the well known function of sorbing gaseous impurities and in particular water, thus minimizing the desorption problems of the photosensitizing dye.

For the manufacturing of the metal oxide layer, nanozeolites modified by superficial functionalization may advantageously be used, as those disclosed e.g. in patent application WO 2008/000457. This solution is advantageous because it allows to obtain a better miscibility of the nanozeolites in solution or in binding matrices. In the latter case matrices made of materials such as e.g. ethyl cellulose or carbon wax/PEG are preferred. In fact they are decomposed at the temperature of the thermal treatment, thus ensuring to obtain photosensitive layers in which the metal oxide and the zeolites are finely and uniformly dispersed. Typically, the thermal treatment is carried out for a time in the order of 30 minutes and at temperatures of about 450°C.

Once obtained the layer of metal oxide, the supporting member is dipped in a bath containing a photosensitive dye that may possibly used in an alcoholic solution, e.g. a solution in ethanol at a concentration of 99.5% by weight. The oxide layer is kept immersed during a time in the order of 16 hours.

Dyes that can be used in the manufacturing of the cell according to the present invention are e.g. those generally known under the chemical formula $ML_2(X)_2$, wherein L indicates a 2,2'-bipyridyl-4,4'-dicarboxylic group, M indicates an element chosen between ruthenium and osmium and X indicates a halogen, a cyanide group or a thiocyanate. At the end of this process the metal oxide layer is coated with a thin layer of dye that is bound thereto by covalent bonds.

The invention will now be described with reference to the following examples.

EXAMPLE 1

Two samples are prepared, one sample comprising a layer of titanium dioxide powders obtained from the commercial product DyeSol 90-T and the other one comprising the same powders of titanium dioxide mixed with powders of nanozeolites in the amount of 4% by weight. In both the samples the layers are made by depositing the powders by screen printing and subsequently by sintering them through a thermal process at 450°C during 30 minutes. The two layers so obtained are subsequently subjected to a process of sorption of a photosensitive dye, the process consisting in dipping each sample in a solution cis-bis(isothiocyanate)bis(2,20-bipyridyl-4,40-dicarboxylate)ruthenium(II) bis-tetrabutylammonium and ethanol having a concentration of 99.5% by weight for a time of 16 hours.

An aging treatment is carried out in a humid atmosphere (85% relative humidity at 85°C) and the degree of dye desorption is compared. The measure of the charge separation is evaluable by photocurrent measurement similar to which are described in the scientific article Zakeeruddin et al "Design, Synthesis, and Application of Amphiphilic Ruthenium Polypyridyl Photosensitizers in Solar Cells Based on Nanocrystalline TiO2 Films", published on Langmuir 18, pagg. 952-954 in the 2002. On the basis of this measurement it has been possible to observe a lower desorption level of the photosensitive dye in the sample comprising the layer formed of powders of titanium dioxide and nanozeolites.

EXAMPLE 2

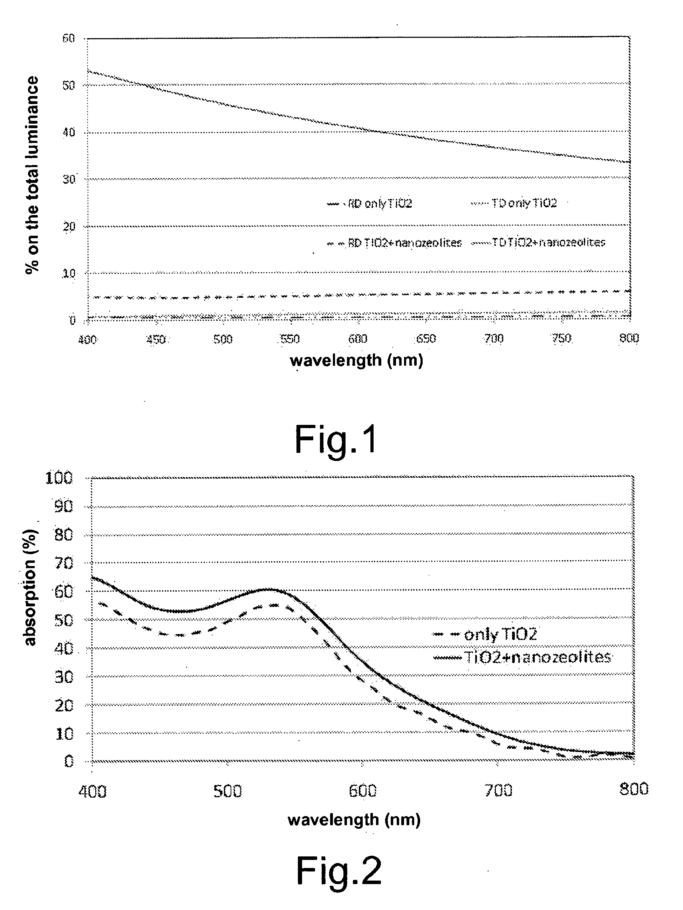

Two other samples as described in the example 1 are prepared and light diffusion measurements are then carried out by using a spectrophotometer equipped with an Ulbrich sphere in reflectance and transmittance mode. The measures show an increase in the light diffusion both transmitted and reflected in the sample comprising the layer formed of powders of titanium dioxide and nanozeolites with respect to the sample exclusively formed of powders of titanium dioxide (Fig.1).

On the same samples, a dye loading process has been applied with commercial N719 dye. The samples have been dried for 60 minutes at 120°C. A solution of the dye has been prepared in ethanol with a concentration 0.3 mM. The dye loading has been carried out by immersing the sample in the solution for 27 hours at RT. After that, the sample has been cleaned by ethanol to eliminate the exceeding dye.

Fig. 2 shows the absorbance measurement for the two samples with the same thickness. The loading in the case of the sample with nanozeolites was lower (25% less). Nevertheless the optical absorbance was increased.

Claims

1. A dye sensitized solar cell comprising a pair of electrodes serving as anode and cathode, respectively, between which an electrolytic solution is arranged, said anode comprising a supporting member on which a metal oxide layer comprising powders of titanium dioxide and nanozeolites is arranged, **characterized in that** the average diameter of the powders of titanium dioxide is comprised between 3 and 30 nm and at least a ten percent with respect to the total number of the powders of nanozeolites have the average diameter comprised between 230 and 320 nm.

2. A solar cell according to the claim 1, wherein the average diameter of the powders of titanium dioxide is comprised between 10 and 25 nm.

3. A solar cell according to claim 1, wherein at least a fifty percent with respect to the total number of the powders of nanozeolites have the average diameter comprised between 230 and 320 nm.

4. A solar cell according to claim 1, wherein the average diameter of all the powders of nanozeolites is comprised between 230 and 320 nm.

5. A solar cell according to any of claims 1, wherein the percentage by weight of the powders of nanozeolites is comprised between 2 and 30% of the total weight of the metal oxide layer.

6. A solar cell according to any of claims 5, wherein the percentage by weight of the powders of nanozeolites is comprised between 4 and 10% of the total weight of the metal oxide layer.

7. A solar cell according to any of claims 6, wherein the percentage by weight of the powders of nanozeolites is comprised between 4 and 6% of the total weight of the metal oxide layer.

8. A solar cell according to any of claims 1, wherein the nanozeolites are superficially functionalized.

Patentansprüche

1. Farbstoffsolarzelle (DSC), aufweisend ein Paar Elektroden, die als Anode und Kathode dienen, zwischen denen eine elektrolytische Lösung angeordnet ist, wobei die Anode ein Stützelement aufweist, auf dem eine Titandioxidpulver und Nanozeolithpulver umfassende Metalloxidschicht angeordnet ist, **dadurch gekennzeichnet, dass** der durschnittschliche Durchmesser der Titandioxidpulver zwischen 3 und 30 nm beträgt und wenigstens zehn Prozent in Bezug auf die Gesamtanzahl der Nanozeolithpulver einen durchschnittlichen Durchmesser zwischen 230 und 320 nm aufweisen.

2. Solarzelle nach Anspruch 1, wobei der durchschnittliche Durchmesser der Titandioxidpulver zwischen 10 und 25 nm beträgt.

3. Solarzelle nach Anspruch 1, wobei wenigstens fünfzig Prozent bezogen auf die Gesamtanzahl der Nanozeolithpulver einen durchschnittlichen Durchmesser von zwischen 230 und 320 nm aufweisen.

4. Solarzelle nach Anspruch 1, wobei der durchschnittliche Durchmesser aller Nanozeolithpulver zwischen 230 und 320 nm beträgt.

5. Solarzelle nach Anspruch 1, wobei der Anteil in Gewichtsprozent der Nanozeolithpulver zwischen 2 und 30 Prozent des Gesamtgewichts der Metalloxidschicht beträgt.

6. Solarzelle nach Anspruch 5, wobei der Anteil in Gewichtsprozent der Nanozeolithpulver zwischen 4 und 10 Prozent des Gesamtgewichts der Metalloxidschicht beträgt.

7. Solarzelle nach Anspruch 6, wobei der Anteil in Gewichtsprozent der Nanozeolithpulver zwischen 4 und 6 Prozent des Gesamtgewichts der Metalloxidschicht beträgt.

8. Solarzelle nach Anspruch 1, wobei die Nanozeolithe oberflächenfunktionalisiert sind.

Revendications

1. Cellule solaire sensibilisée par un colorant comprenant une paire d'électrodes servant d'anode et de cathode, respectivement, entre lesquelles une solution électrolytique est disposée, ladite anode comprenant un élément support sur lequel une couche d'oxyde métallique comprenant des poudres de dioxyde de titane et des nanozéolites est disposée, **caractérisée en ce que** le diamètre moyen des poudres de dioxyde de titane est compris entre 3 et 30 nm et au moins dix pourcents par rapport au nombre total des poudres de nanozéolites ont le diamètre moyen compris entre 230 et 320 nm.

2. Cellule solaire selon la revendication 1, dans laquelle le diamètre moyen des poudres de dioxyde de titane est compris entre 10 et 25 nm.

3. Cellule solaire selon la revendication 1, dans laquelle au moins cinquante pourcents par rapport au nombre total des poudres de nanozéolites ont le diamètre moyen compris entre 230 et 320 nm.

4. Cellule solaire selon la revendication 1, dans laquelle le diamètre moyen de toutes les poudres de dioxyde de titane est compris entre 230 et 320 nm.

5. Cellule solaire selon l'une quelconque des revendications 1, dans laquelle le pourcentage en poids des poudres de nanozéolites est compris entre 2 et 30 % du poids total de la couche d'oxyde métallique.

6. Cellule solaire selon l'une quelconque des revendications 5, dans laquelle le pourcentage en poids des poudres de nanozéolites est compris entre 4 et 10 % du poids total de la couche d'oxyde métallique.

7. Cellule solaire selon l'une quelconque des revendications 6, dans laquelle le pourcentage en poids des poudres de nanozéolites est compris entre 4 et 6 % du poids total de la couche d'oxyde métallique.

8. Cellule solaire selon l'une quelconque des revendications 1, dans laquelle les nanozéolites sont fonctionnalisées en surface.

# Fig.1

# Fig.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20080115831 A1
- JP 20052516005 A
- JP 200841746 A
- JP 2008201655 B
- JP 2006124267 A
- WO 2008000457 A

### Non-patent literature cited in the description

- **Y. CHIBA et al.** Dye sensitized solar cells with conversion efficiency of 11%. *J. Appl. Phys.,* 2006, L638-640
- *Bulletin Korean Chem. Soc.,* 2002, vol. 23, 140-142
- Thermal stability of dye-sensitized solar cells with current collecting grid. Solar Energy Materials and Solar Cells, June 2009, vol. 93, 1110-1115
- **ZAKEERUDDIN et al.** Design, Synthesis, and Application of Amphiphilic Ruthenium Polypyridyl Photosensitizers in Solar Cells Based on Nanocrystalline TiO2 Films. *Langmuir,* 2002, vol. 18, 952-954